# EUROPEAN PATENT APPLICATION

(11) **EP 2 532 634 A1**
(43) Date of publication of application: **12.12.2012**
(21) Application number: 10843009.1
(22) Date of filing: 24.12.2010
(51) Int. Cl.: C04B 35/00, C23C 14/34, H01M 4/525

(54) **METHOD FOR MANUFACTURING SINTERED LICOO2, AND SPUTTERING TARGET**

(30) Priority: 15.01.2010 JP 2010006753
(71) Applicant: Ulvac, Inc., Chigasaki-shi Kanagawa 253-8543 (JP)
(72) Inventor: KIM, Poong, Susono-shi Shizuoka 410-1231 (JP); SUU, Koukou, Susono-shi Shizuoka 410-1231 (JP); HASHIGUCHI, Shouichi, Tomisato-shi Chiba 286-0225 (JP); MIKASHIMA, Takanori, Tomisato-shi Chiba 286-0225 (JP); UEZONO, Ryouta, Kirishima-shi Kagoshima 899-6301 (JP)
(74) Representative: Markfort, Iris-Anne Lucie
(86) International application number: PCT/JP2010/007510
(87) International publication number: WO 2011/086650

(57) **Abstract**

[Object] To provide a manufacturing method for a LiCoO₂ sintered body capable of manufacturing a sintered body having a high density constantly.

[Solving Means] A manufacturing method for a LiCoO₂ sintered body according to an embodiment of the present invention includes a step of molding and a step of sintering by cold isostatic press method. A molding pressure is 1000 kg/cm² or more, a sintering temperature is equal to or higher than 1050°C and equal to or lower than 1120°C, and a sintering time is 2 hours or more. Accordingly, a LiCoO₂ sintered body having a relative density of 90% or more, a specific resistance of 3 kΩ/cm or less, and an average particle size of equal to or larger than 20 µm and equal to or smaller than 50 µm can be manufactured constantly.

## Description

### Technical Field

The present invention relates to a manufacturing method for a LiCoO₂ sintered body which is provided to form a positive electrode of a thin film lithium secondary cell, for example, and a sputtering target.

### Background Art

In recent years, a thin film lithium secondary cell has been developed. The thin film lithium secondary cell has a configuration that a solid electrolyte is sandwiched between a positive electrode and a negative electrode. For example, LiPON (Lithium Phosphorus Oxynitride) film is used for the solid electrolyte, LiCoO₂ (Lithium Cobalt Oxide) film is used for the positive electrode, and a metal Li film is used for the negative electrode.

As a method of forming a LiCoO₂ film, a method of sputtering a target including LiCoO₂ and forming a LiCoO₂ film on a substrate has been known. In Patent Document 1 which will be described later, although a method of forming a LiCoO₂ film on a substrate by sputtering a LiCoO₂ target having a resistivity of 3 to 10 kΩ/cm by DC pulse discharge is described, a manufacturing method for the LiCoO₂ target is not described in detail.

Generally, manufacturing methods for a sputtering target include a method of molding by dissolving a material and a method of sintering a molded body of a raw material powder. Moreover, examples of a quality demanded for the sputtering target include that, first, its purity is controlled, second, it has a fine crystalline structure and a narrow grain size distribution, third, its composition distribution is uniform, and, fourth, a relative density of a sintered body is high in a case where a powder is used as a raw material. Here, the relative density means a ratio between a density of a porous material and a density of a material having the same composition in a state which has no air holes.

Patent Document 1: Japanese Patent Application Laid-open No. 2008-45213

### Disclosure of the Invention

### Problem to be solved by the Invention

When the sputtering target is configured of a sintered body of a raw material powder, the first to third compositional requirements of a material can be satisfied relatively easily by adjusting the raw material powder. However, it is not easy to attain the high density of the fourth requirement currently because it is greatly affected by unique properties (physical properties and chemical properties) of the material. Particularly, since a LiCoO₂ crystal has a layered structure and it is liable to be peeled off between its layers, there is a problem that it is easy to be broken when forming the sintered body and after forming the sintered body, and that a sintered body having a high density cannot be manufactured constantly.

In view of the circumstances as described above, an object of the present invention is to provide a manufacturing method for a LiCoO₂ sintered body which is capable of manufacturing a sintered body having a high density constantly and a sputtering target.

### Means for solving the Problem

In order to achieve the object described above, a manufacturing method for a LiCoO₂ sintered body according to an embodiment of the present invention includes a step of molding a LiCoO₂ powder preliminarily by cold isostatic press method at a pressure of 1000 kg/cm² or higher. A preliminary molded body of the LiCoO₂ powder is sintered at a temperature of equal to or higher than 1050°C and equal to or lower than 1120°C.

A sputtering target according to an embodiment of the present invention includes a LiCoO₂ sintered body and has a relative density of 90% or more, a specific resistance of 3 kΩ/cm or less, and an average particle size of equal to or larger than 20 µm and equal to or smaller than 50 µm.

### Brief Description of Drawings

[Fig. 1] Fig. 1 is a diagram schematically showing an x-ray diffraction measurement result of a LiCoO₂ powder after heat treatment, which will be described in a first embodiment of the present invention.
[Fig. 2] Fig. 2 is a diagram showing a full width at half maximum of a peak on a (003) plane at each processing temperature in the x-ray diffraction measurement result of Fig. 1 compared with a case of using a different raw material powder.
[Fig. 3] Fig. 3 is a diagram schematically showing a differential thermal analysis result of the LiCoO₂ powder which will be described in the first embodiment of the present invention.
[Fig. 4] Fig. 4 is an experimental result showing a relationship between a molding pressure and a relative density of the LiCoO₂ sintered body according to the first embodiment of the present invention.
[Fig. 5] Fig. 5 is an experimental result showing a relationship between a sintering time and the relative density of the LiCoO₂ sintered body according to the first embodiment of the present invention.
[Fig. 6] Fig. 6 is an experimental result showing a relationship between a sintering temperature and the relative density of the LiCoO₂ sintered body according to the first embodiment of the present invention.
[Fig. 7] Fig. 7 is a diagram showing an example of a temperature profile of a sintering furnace which will be described in the first embodiment of the present invention.
[Fig. 8] Fig. 8 is a diagram showing another example of the temperature profile of the sintering furnace which will be described in the first embodiment of the present invention.
[Fig. 9] Fig. 9 is a diagram showing an example of the temperature profile of the sintering furnace which will be described in a second embodiment of the present invention; and
[Fig. 10] Fig. 10 is a diagram showing another example of the temperature profile of the sintering furnace which will be described in the second embodiment of the present invention. Best Mode(s) for Carrying Out the Invention

A manufacturing method for a LiCoO₂ sintered body according to an embodiment of the present invention includes a step of molding a LiCoO₂ powder preliminarily by cold isostatic press method at a pressure of 1000 kg/cm² or higher. A preliminary molded body of the LiCoO₂ powder is sintered at a temperature of equal to or higher than 1050°C and equal to or lower than 1120°C.

According to the manufacturing method, a LiCoO₂ sintered body having a high relative density of 90% or more can be manufactured constantly.

The step of sintering the preliminary molded body may hold the preliminary molded body at the temperature for 2 hours or more. If the sintering time is less than 2 hours, it is difficult to obtain the relative density of 90% or more. In a case where the sintering time is more than 2 hours, the upper limit of the sintering time is not particularly limited because an significant increase effect on the relative density cannot be found even if the sintering time is more than that.

The preliminary molded body may be sintered in the atmosphere or in an oxygen atmosphere. At any of the sintering atmosphere, the LiCoO₂ sintered body having a high relative density of 90% or more can be manufactured constantly.

The step of molding the LiCoO₂ powder preliminarily may include a step of adding a binder to the LiCoO₂ powder. In this case, the LiCoO₂ powder added with the binder is molded by the cold isostatic press method. A molded body of the LiCoO₂ powder added with the binder is pulverized. The LiCoO₂ powder thus pulverized is molded by the cold isostatic press method.
Accordingly, also in a case of manufacturing a relatively large LiCoO₂ sintered body, the LiCoO₂ sintered body having a high relative density of 90% or more can be manufactured constantly.

The manufacturing method for a LiCoO₂ sintered body described above may further include a step of debinding the preliminary molded body of the LiCoO₂ powder including the binder at a temperature lower than a sintering temperature before the step of sintering the molded body. Accordingly, it is possible to manufacture the LiCoO₂ sintered body having a high purity by preventing a carbon derived from the binder from remaining.

A sputtering target according to an embodiment of the present invention includes a LiCoO₂ sintered body and has a relative density of 90% or more, a specific resistance of 3 kΩ/cm or less, and an average particle size of equal to or larger than 20 µm and equal to or smaller than 50 µm. Accordingly, it is possible to suppress an occurrence of a particle and perform a stable sputtering by superimposed discharge with direct-current power and high-frequency power.

Hereinafter, the embodiment of the present invention will be described with reference to the drawings.

### (First Embodiment)

In this embodiment, a cold isostatic press (CIP) & sintering method which is expected to have a low remaining stress due to sintering is employed in order to manufacture a LiCoO₂ (Lithium Cobalt Oxide) sintered body having a uniform crystalline structure, a high relative density, and a low specific resistance value. Here, an effect of a preliminary molding pressure, a sintering temperature, and a sintering time on a LiCoO₂ sintered body will be described first.

### [Preliminary Review 1: Change in Crystalline Properties]

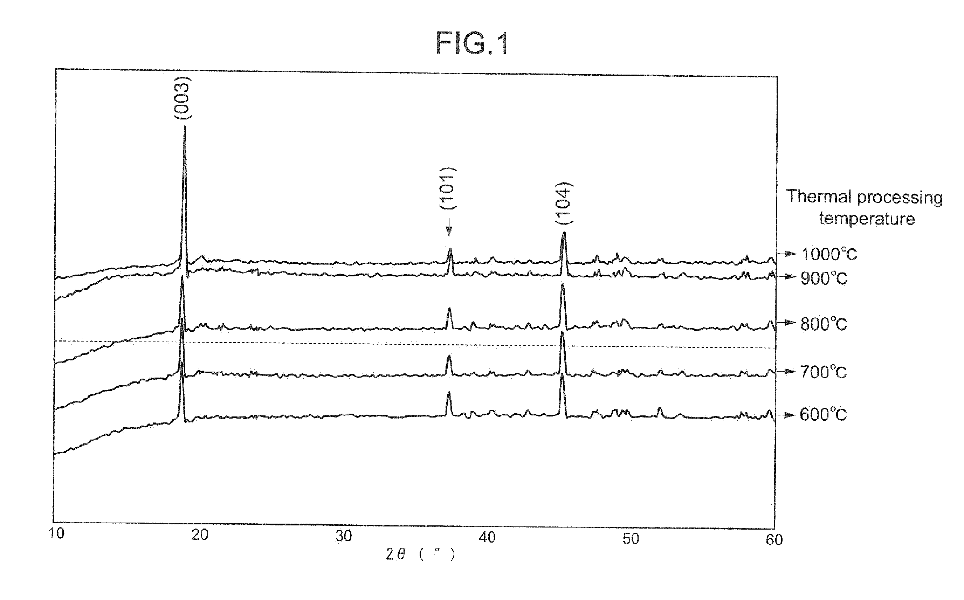

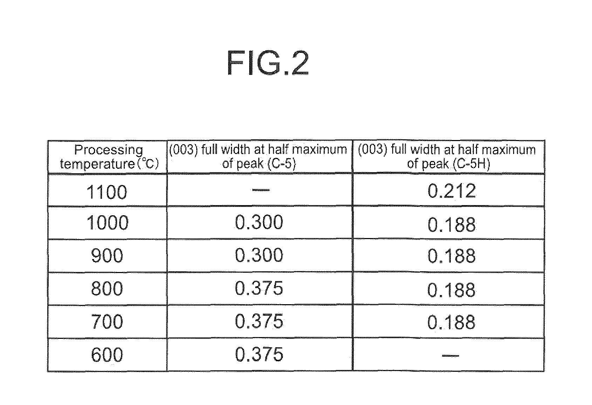

Fig. 1 is a schematic diagram showing an x-ray diffraction measurement result (radiation source: CuK*α*) of the LiCoO₂ powder after heat treatment of 600°C, 700°C, 800°C, 900°C, and 1000°C in the atmosphere. As a measuring apparatus, an x-ray diffraction apparatus "RINT1000" manufactured by Rigaku Corp. was used. As a sample of a LiCoO₂ powder, a commercially available powder ("cell seed (registered trademark) C-5" manufactured by Nippon Chemical industrial Co., LTD.) was used. The heat treatment time was set to be 30 minutes, respectively. Then, a full width at half maximum (FWHM) of a peak on a (003) plane and a peak intensity ratio (area ratio) ((104) / (003)) between a (104) plane and the (003) plane were measured for each temperature from an XRD result at each of the temperatures. The change in the full width at half maximum in a case of using a commercially available powder ("cell seed (registered trademark) C-5H" manufactured by Nippon Chemical industrial Co., LTD.) was also measured similarly at the same time. The result is shown in Fig. 2.

From the results of Fig. 1 and Fig. 2, although, in the "cell seed (registered trademark) C-5", a significant peak shift was not found with the heating up to 1000°C, an increase in the full width at half maximum and a change in the peak intensity ratio were confirmed at a temperature of equal to or higher than 900°C. Therefore, crystal grain growth of LiCoO₂ is considered to be caused at a temperature of equal to or higher than 900°C. On the other hand, although, in the "cell seed (registered trademark) C-5H", a change in the full width at half maximum is not found up to 1000°C and crystal grain growth is not caused at a temperature of equal to or lower than 1000°C, the crystal grain growth is considered to be caused at a temperature between 1000°C to 1100°C because the full width at half maximum is changed at 1100°C.

### [Preliminary Review 2: Change in State due to Heating]

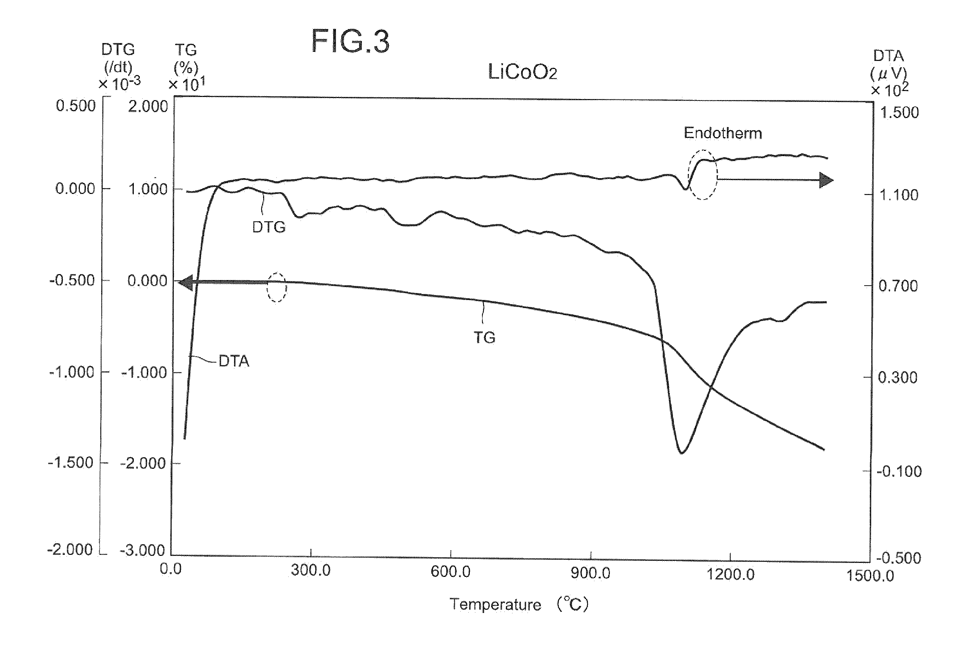

Fig. 3 is an experimental result schematically showing a change in state of a commercially available LiCoO₂ powder ("cell seed (registered trademark) C-5" manufactured by Nippon Chemical industrial Co., LTD.) when it is heated in an Ar atmosphere. As a measuring apparatus, a differential thermal analysis apparatus "TGD-9600" manufactured by ULVAC-RIKO, Inc. was used. When a change in thermogravimetry (TG) of a sample heated in a flow of Ar at a constant rate of temperature increase (20°C /min.) was examined, it was confirmed that there was a slight decrease in weight up to about 1050°C and that a rapid decrease in weight was caused at a temperature higher than that, as shown in Fig. 3. The gradual decrease in weight up to 1050°C is considered to be caused due to a gas release from the sample. Further, since an endothermic reaction was indicated at about 1100°C, it was confirmed that a melting was caused near the temperature.

### [Preliminary Review Result]

Although a change in crystalline properties of the sample placed in the atmosphere which is held at a high temperature and a change in state of the sample measured in a flow of Ar while increasing temperature are different in the condition, the following findings can be obtained. That is, a temperature at which significant crystal grain union (growth) of the LiCoO₂ is started to be caused is equal to or higher than 1050°C and thus it is determined that a temperature condition in which sintering of the LiCoO₂ powder is proceeded is appropriate to be in a range of equal to or higher than 1050°C. It should be noted that a melting point of the LiCoO₂ is 1130°C.

Based on these findings, a small sample having a diameter of 60 mm was produced experimentally in order to clarify an effect of a sintering condition on the LiCoO₂ sintered body (molding pressure, sintering temperature, and holding time).

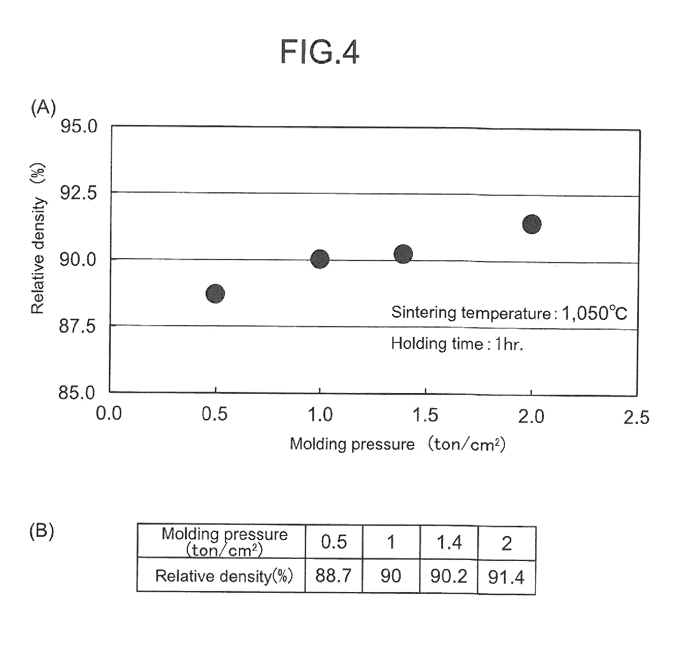

First, a dependency of the preliminary molding pressure on the relative density of the sintered body was examined. A plurality of samples of a preliminary molded body in which a pressure was changed from 500 kg/cm² (0.5 ton/cm²) to 2000 kg/cm² (2 ton/cm²) when it was formed were prepared and the relative density of each of the samples heated in the atmosphere at a temperature of 1050°C for 1 hour was measured. The preliminary molded body was formed by using CIP method. The result was shown in Figs. 4A and 4B. As shown in Figs. 4A and 4B, it was confirmed that the pressure when forming the preliminary molded body affected on the relative density of the sintered body and that the relative density of equal to or more than 90% could be obtained if the pressure was equal to or higher than 1000 kg/cm².

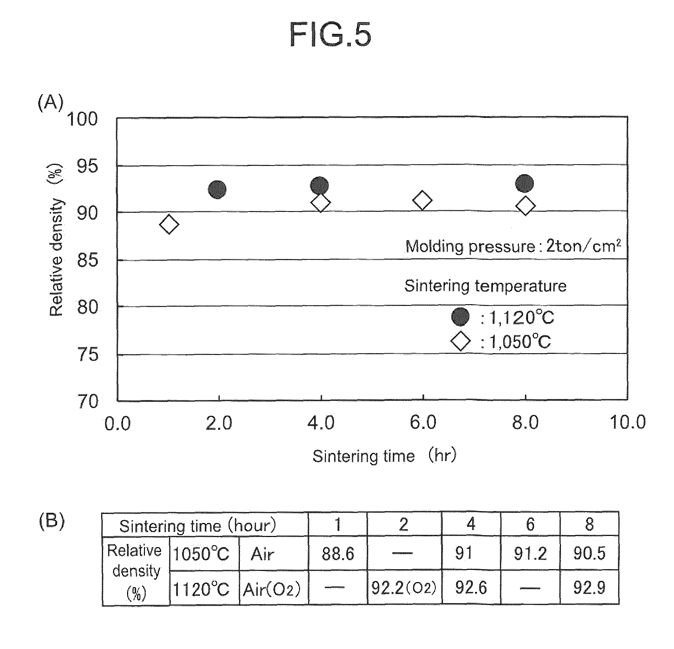

Next, the pressure when forming the preliminary molded body was set to be 2000 kg/cm² and the sintering temperature was set to be 1050°C and 1120°C. Then, a sintering time dependency which affects the relative density of the sintered body was examined. The sintering atmosphere was the atmosphere in the samples sintered at 1050°C and in the samples sintered at 1120°C for 4 hours and 8 hours, and was an oxygen (O₂) atmosphere under ordinary pressure in the sample sintered at 1120°C for 2 hours. The result was shown in Figs. 5A and 5B.

As shown in Figs. 5A and 5B, in a case of sintering temperature of 1050°C, although the relative density of 90% or more could not be obtained when the sintering time was 1 hour which is the same condition as the samples of Figs. 4A and 4B, unlike the samples of Figs. 4A and 4B, it was confirmed that the relative density of 90% or more could be obtained by isothermal holding for 4 hours or more. On the other hand, in a case of sintering temperature of 1120°C, it was confirmed that the relative density of 90% or more could be obtained from any of the samples. Moreover, it was confirmed that both the oxygen atmosphere and the atmosphere can be used as the sintering atmosphere because the relative density of 90% or more could be obtained from the sample sintered in the oxygen atmosphere. It should be noted that a phenomenon which represents an increase in the relative density due to a prolonged sintering time was not found regardless of the sintering temperature. It can be considered that this is because a welding pressure is not added when sintering.

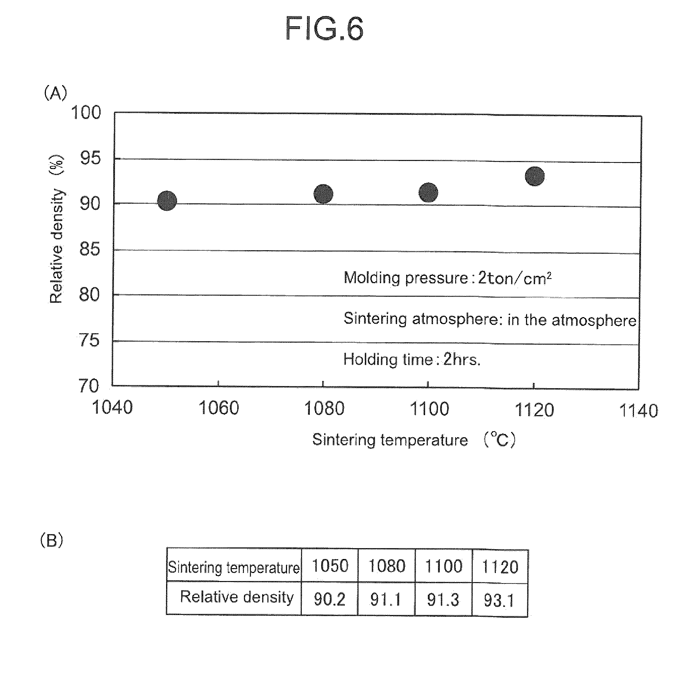

Furthermore, the sintering temperature dependency was examined by fixing the molding pressure of the preliminary molded body to 2000 kg/cm² and the sintering time to 2 hours, respectively. The result is shown in Figs. 6A and 6B. It was confirmed that the relative density of 90% or more could be obtained by all the samples at the sintering temperatures of 1050°C, 1080°C, 1100°C and 1120°C. Although the sintering temperature dependency on the relative density of the sintered body is regarded as large generally, the result showed that an effect of the sintering temperature on the relative density was small in this temperature range in relation to the LiCoO₂.

Based on these review results, the manufacturing method for a LiCoO₂ sintered body according to an embodiment of the present invention includes a step of molding the LiCoO₂ powder preliminarily by the cold isostatic press method at a pressure of 1000 kg/cm² or higher. The preliminary molded body of the LiCoO₂.powder is sintered at a temperature of equal to or higher than 1050°C and equal to or lower than 1120°C.

As a raw material powder, a LiCoO₂ powder having an average particle size (D₅₀) of, for example, equal to or smaller than 20 µm, is used. The LiCoO₂ powder may be a commercially available powder or may be formed by a wet method or a dry method. Examples of the commercially available raw material powder include "cell seed (registered trademark) C-5" or "cell seed (registered trademark) C-5H" manufactured by Nippon Chemical industrial Co., LTD.).

As the manufacturing method for a LiCoO₂ sintered body, a CIP & sintering method which includes a step of molding by cold isostatic press method and a step of sintering is employed. According to the manufacturing method described above, the LiCoO₂ sintered body having a relative density of 90% or more can be manufactured constantly.

In the CIP molding, isostatic pressing is performed at a predetermined molding pressure after the powder is filled in a rubber mold and the rubber mold is sealed in a laminate bag. The molding pressure is set to be 1000 kg/cm² or higher. In a case where the molding pressure is lower than 1000 kg/cm², it is difficult to obtain the sintered body having a relative density of 90% or more constantly because the molding pressure is too low. The higher the molding pressure, the higher the relative density tends to be. The upper limit of the molding pressure is not particularly limited, and it is, for example, 3000 kg/cm².

On the other hand, the sintering temperature is set to be equal to or higher than a temperature at which crystal grain growth of LiCoO₂ is caused. Accordingly, the sintering of the raw material powder is facilitated and it becomes possible to obtain the sintered body having a high density. In a case of the sintering temperature of lower than 1050°C, it is difficult to obtain the sintered body having a relative density of 90% or more because the crystal grain growth is not facilitated. On the contrary, in a case of the sintering temperature of higher than 1120°C, a crystalline structure of the sintered body is formed of a large crystalline grain and the property of "hard but brittle" becomes significant.

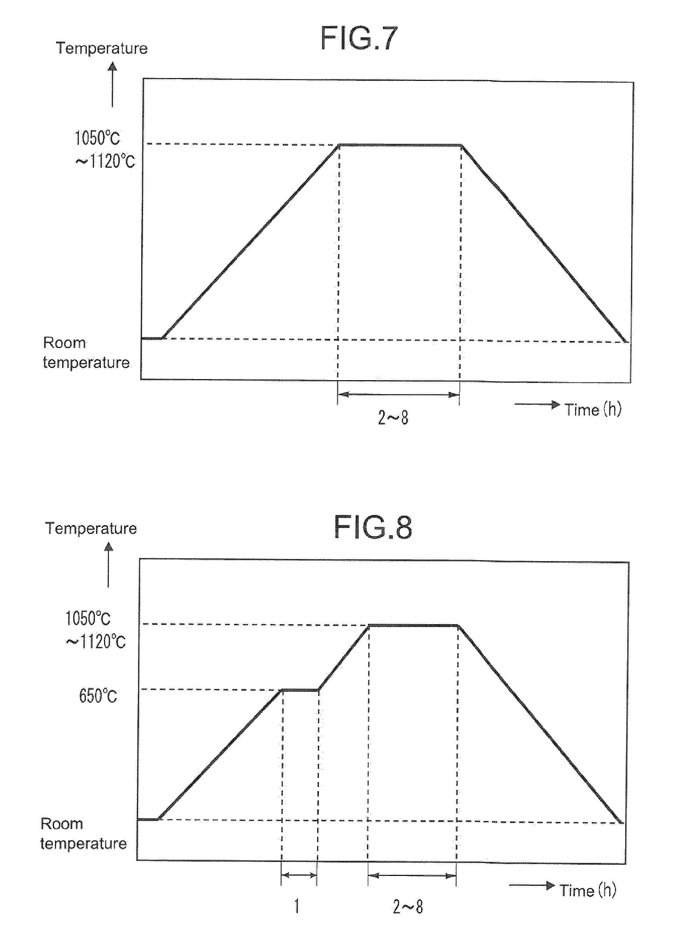

The sintering temperature (holding time at sintering temperature) of the preliminary molded body can be 2 hours or more. The LiCoO₂ sintered body having a relative density of 90% or more can be obtained with the sintering time of 2 hours or more. That is, in a case of the sintering time of less than 2 hours, it is difficult to obtain a relative density of 90% or more. In a case where the sintering time is equal to or more than 2 hours, the upper limit of the sintering time is not particularly limited because a significant increase effect on the relative density cannot be found even if the sintering time is more than that. The sintering time is set to be 8 hours at the longest taking into consideration of productivity or the like. Fig. 7 shows an example of a temperature profile of a sintering furnace in the sintering step of the preliminary molded body described above. The rate of temperature increase and the rate of temperature decrease are not particularly limited, and they are set to be, for example, 100°C/Hr. or less.

A degassing step of the preliminary molded body may be performed additionally as necessary. It is possible to remove a gas component included in the raw material powder reliably by adding the degassing step. Therefore, it is possible to eliminate an effect of a rate of moisture absorption of the raw material powder to be used. In the degassing step, the preliminary molded body is held at a temperature lower than the sintering method for a predetermined time. A degassing temperature is set to be, for example, 600°C to 700°C. The holding time also is not particularly limited, and it is, for example, 1 hour. Fig. 8 shows an example of the temperature profile for the heat treatment including degassing processing and sintering processing for the preliminary sintered body.

According to the manufacturing method, the LiCoO₂ sintered body having a relative density of 90% or more can be manufactured constantly. Accordingly, machine processing can be performed to form the sintered body in a target shape constantly, because the intensity of the sintered body is enhanced and the handling of the sintered body is improved. Further, since durability is obtained also when high power is applied, it is possible to meet a demand for an increase in sputter rate sufficiently.

Furthermore, since the sintered body has the relative density of 90% or more, it is possible to reduce a specific resistance of the sintered body. According to the manufacturing method, the LiCoO₂ sintered body having a specific resistance of equal to or less than 3 kΩ/cm can be obtained. Accordingly, it becomes possible to perform not RF discharge but RF + DC discharge (superimposed discharge of RF and DC) during sputter deposition, a discharge stability is improved, and a sputter rate is expected to be increased.

The average particle size of the sintered body has a strong correlation with the relative density and the mechanical strength of the sintered body. In order to increase the relative density of the sintered body, it is favorable to sinter at a temperature at which LiCoO₂ crystal is likely to grow. Although the relative density is increased and the mechanical intensity is enhanced as the average particle size becomes large along with proceeding of sintering, the "hard but brittle" property becomes significant and resistance to shock is reduced. Favorably, the average particle size of the LiCoO₂ sintered body according to an embodiment of the present invention is equal to or larger than 20 µm and equal to or smaller than 50 µm.

The machine processing of the sintered body includes an outer periphery processing and a surface processing using a lathe. When used as a sputtering target, the sintered body needs to be bonded to a bucking plate. In the bonding, a molten In (indium) may be applied to a bonded surface of the sintered body. A Cu (copper) thin film may be formed in advance on the bonded surface of the sintered body and then the molten In may be applied thereon. After bonding, the target and the bucking plate are washed in a dry environment.

### (Second Embodiment)

On the other hand, in a case of manufacturing a relatively large LiCoO₂ sintered body, it is necessary to increase an intensity of a molded body for maintaining a shape of the molded body because a weight of a preliminary molded body itself. In this regard, it is possible to suppress a reduction of the intensity along with the increase of the preliminary molded body in size by adding a binder to a raw material powder and repeating a molding and a pulverizing. Further, it is possible to remove an impurity component from the preliminary molded body by performing debinding processing and, if necessary, degassing processing at appropriate temperature after manufacturing the preliminary molded body.

The binder is not particularly limited as long as it is a high-molecular material which can be debound by heating processing and, for example, a high-molecular material including polyvinyl acetate or polyvinyl alcohol is used as the binder. A mixed amount of the binder can be set as appropriate and is, for example, less than 2 wt%. This binder is mixed with the LiCoO₂ raw material powder and then dried before it is pulverized to an appropriate size. The pulverization size is not particularly limited and is, for example, less than #500 (less than 25 µm) The mixed powder thus pulverized is pulverized again after being subjected to CIP processing. The preliminary molded body of the LiCoO₂ powder is manufactured by applying CIP processing again to the powder thus granulated, as described above.

For mixing the raw material powder and the binder, Zr (zirconia) ball as a mixed medium and ethanol as a solvent are used, and it is possible to mix and disperse them in a case made of resin while rotating. For drying, a vacuum dryer can be used. As a method other than that, a spray dryer may be used. For pulverizing, a roll mill or a ball mill can be used and for classification, an agglomerated powder is removed by using a sieve of #500. In the CIP molding, isostatic pressing is performed at a predetermined molding pressure after the powder is filled in, for example, a rubber mold (rubber) of 360 mmϕ and the rubber mold is salad in a laminate bag.

A pressure condition of the CIP processing is 1000 kg/cm² or more similarly as the first embodiment described above. The repulverization size is #500 or less, similarly. It is possible to uniform the particle size and disperse the binder by repeating the CIP processing and the pulverization processing alternately, as described above. The number of the repetition is not particularly limited. Since an adhesion intensity of the raw material powder is increased by repeating the processing described above, it becomes possible to enhance the intensity of the preliminary molded body.

The debinding processing of the preliminary molded body may be performed at the same time as the sintering step. However, a bumping of a binder component is prevented by debinding at a temperature lower than the sintering temperature and thus a sintered body having a high density can be obtained. The debinding temperature is not particularly limited and can be, for example, about 300°C. The holding time at the debinding temperature also is not particularly limited and is, for example, 1 hour to 6 hours.

The degassing processing of the preliminary molded body is performed at a temperature higher than the debinding temperature and lower than the sintering temperature. The degassing temperature is not particularly limited. However, it is, for example, 600°C to 700°C and is about 650°C in this embodiment. The holding time at the degassing temperature also is not particularly limited and is, for example, 1 hour.

The preliminary molded body after being debound is sintered by being held at a temperature equal to or higher than 1050°C and equal to or lower than 1120°C for 2 hours or more. Accordingly, the LiCoO₂ sintered body is manufactured. When the LiCoO₂ sintered body having a diameter of about 330 mm and a thickness of 10 mm was manufactured, with the molding pressure of the preliminary molded body of 2000 kg/cm², by performing the debinding processing at 300°C for 1 hour and the sintering processing at 1120°C for 4 hours, the LiCoO₂ sintered body had the relative density of 92%, the average particle size of 40 µm, and the specific resistance of 2 kΩ/cm. At this time, the preliminary molded body and the sintered body did not break when conveying the preliminary molded body to the sintering furnace and taking the sintered body from the sintering furnace. Moreover, a compositional analysis of the sintered body by ICP atomic emission spectroscopy was performed and an increase in the amount of carbon due to the binder was examined by a combustion infrared absorption method using a gas analyzing apparatus manufactured by LECO Corporation. However, it was 60 ppm regardless of existence or non-existence of the addition of the binder.

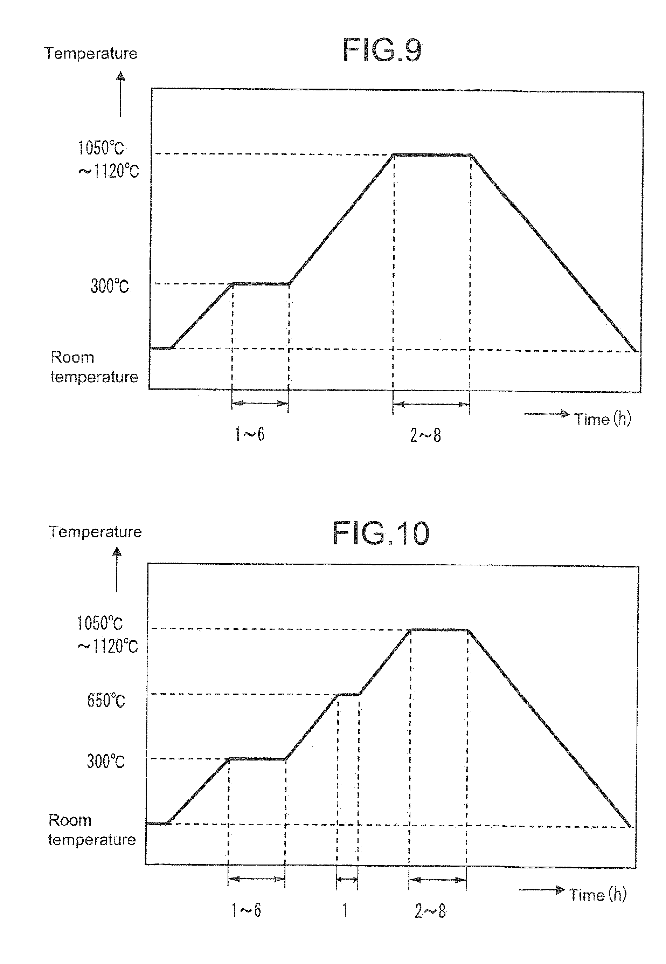

Fig. 9 shows an example of the temperature profile for heat treatment including the debinding processing and sintering processing for the LiCoO₂ preliminary sintered body according to this embodiment. After the preliminary molded body was loaded into the heating furnace, the inside of the furnace is heated to 300°C at a predetermined rate of temperature increase. After increasing temperature, the preliminary molded body is debound by being held at the temperature for 1 to 6 hours. Next, the preliminary molded body was heated to the sintering temperature (1050°C to 1120°C) and was sintered by being held at the temperature for 2 to 8 hours. After sintering, the inside the furnace was cooled down to room temperature at a predetermined rate of temperature decrease. The rate of temperature increase and the rate of temperature decrease are not particularly limited and are, for example, 100°C/Hr. or less.

Fig. 10 shows an example of the temperature profile of the heat treatment including the debinding processing, the degassing processing, and the sintering processing. After debinding, the inside temperature of the furnace is increased to 650°C and the preliminary sintered body is degassed by being held at the temperature for 1 hour. After that, the sintering processing is performed by holding at the sintering temperature for a predetermined time.

### Example 1

In the following, an example of the present invention will be described, but the present invention does not limited thereto.

### (Example 1)

### (Example 1-1)

A LiCoO₂ raw material powder ("cell seed (registered trademark) C-5" manufactured by Nippon Chemical industrial Co., LTD.) having an average particle size (D50, the same shall apply hereinafter) of 5 to 6 µm was CIP molded by using a rubber mold having a size of ϕ150 mm at 2000 kg/cm². The preliminary molded body thus obtained was sintered in the atmosphere at 1050°C for 8 hours. The break of the sintered body was not recognized during machine processing into the target shape. When performing a discharge test of the target, a sustained stable RF+DC discharge was confirmed. When the relative density, the specific resistance value, and the average particle size of the obtained sintered body were measured, the relative density was 90%, the specific resistance value was 3 kΩ/cm, and the average particle size was about 20 µm.

It should be noted that the relative density was obtained by a calculation of a ratio of an appearent density and a theoretical density (5.16 g/cm³) of the sintered body. With respect to the appearent density, a volume was obtained by measuring sizes of an outer periphery and a thickness of the obtained sintered body using a vernier caliper, a micrometer, or a three-dimensional measuring instrument after the obtained sintered body was machine processed. Next, a weight of the obtained sintered body was measured by an electric balance and then the appearent density was obtained from the expression of (weight/volume).
The measurement of the specific resistance value was performed by a four point prove method. As she measuring apparatus, "RT-6" manufactured by Napson Corporation was used. The measurement of the average particle size was determined by visual inspection using a cross-sectional SEM image of the sintered body, based on a particle size table of "American Society for Testing and Materials (ASTM) E 112" (Japanese Industrial Standards (JIS) G0551).

### (Example 1-2)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ150 mm at 2000 kg/cm². The preliminary molded body thus obtained was sintered in the atmosphere at 1120°C for 4 hours. The break of the sintered body was not recognized during machine processing into the target shape. When performing a discharge test of the target, a sustained stable RF+DC discharge was confirmed. The relative density of the sintered body thus obtained was 92%, the specific resistance value was 2 kΩ/cm, and the average particle size was about 50 µm.

### (Example 1-3)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ150 mm at 1500 kg/cm². The preliminary molded body thus obtained was sintered in the atmosphere at 1120°C for 3 hours. The break of the sintered body was not recognized during machine processing into the target shape. When performing a discharge test of the target, a sustained stable RF+DC discharge was confirmed. The relative density of the sintered body thus obtained was 90.5%, the specific resistance value was 3 kΩ/cm, and the average particle size was about 40 µm.

### (Example 1-4)

A LiCoO₂ raw material powder ("cell seed (registered trademark) C-5H" manufactured by Nippon Chemical industrial Co., LTD.) having an average particle size of 6 to 7 µm was CIP molded by using a rubber mold having a size of ϕ150 mm at 1500 kg/cm². The preliminary molded body thus obtained was sintered in the atmosphere at 1120°C for 3 hours. The break of the sintered body was not recognized during machine processing into the target shape. When performing a discharge test of the target, a sustained stable RF+DC discharge was confirmed. The relative density of the sintered body thus obtained was 91%, the specific resistance value was 3 kΩ/cm, and the average particle size was about 40 µm.

### (Comparative example 1-1)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ150 mm at 2000 kg/cm². The preliminary molded body thus obtained was sintered in the atmosphere at 950°C for 3 hours. The break of the sintered body after sintering was not recognized. The relative density of the sintered body thus obtained was 80%, the specific resistance value was 12 kΩ/cm, and the average particle size was about 7 µm.

### (Comparative example 1-2)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ150 mm at 950 kg/cm². The preliminary molded body thus obtained was sintered in the atmosphere at 1050°C for 1 hour. The break of the sintered body after sintering was not recognized. The relative density of the sintered body thus obtained was 88%, the specific resistance value was 7 kΩ/cm, and the average particle size was about 20 µm.

### (Comparative example 1-3)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ150 mm at 2000 kg/cm². The preliminary molded body thus obtained was sintered in the atmosphere at 1130°C for 3 hours. Although the break of the sintered body after sintering was not recognized, a lot of chipping was generated during machine processing into the target shape. The relative density of the sintered body thus obtained was 93%, the specific resistance value was 2 kΩ/cm, and the average particle size was about 100 µm.

### (Comparative example 1-4)

A LiCoO₂ raw material powder ("cell seed (registered trademark) C-5H" manufactured by Nippon Chemical industrial Co., LTD.) having an average particle size of 6 to 7 µm was CIP molded by using a rubber mold having a size of ϕ150 mm at 950 kg/cm². The preliminary molded body thus obtained was sintered in the atmosphere at 1050°C for 2 hours. The break of the sintered body after sintering was not recognized. The relative density of the sintered body thus obtained was 86%, the specific resistance value was 8 kΩ/cm, and the average particle size was about 15 µm.

The conditions and the results of the example 1 will be shown in table 1 collectively.

**[table 1]**

| | Molding pressure (kg/cm²) | Sintering temperature (°C) | Sintering time (h) | Specific resistance (kΩcm) | Relative density (%) | Average particle size (*µ*m) |
|---|---|---|---|---|---|---|
| Example 1-1 | 2000 | 1050 | 8 | 3 | 90 | 20 |
| Example 1-2 | 2000 | 1120 | 4 | 2 | 92 | 50 |
| Example 1-3 | 1500 | 1120 | 3 | 3 | 90.5 | 40 |
| Example 1-4 | 1500 | 1120 | 3 | 3 | 91 | 40 |
| Comparative example 1-1 | 2000 | 950 | 3 | 12 | 80 | 7 |
| Comparative example 1-2 | 1000 | 1050 | 1 | 7 | 88 | 20 |
| Comparative example 1-3 | 2000 | 1130 | 3 | 2 | 93 | 100 |
| Comparative example 1-4 | 1000 | 1050 | 2 | 8 | 86 | 15 |

From the results of the table 1, when the molding pressure of the preliminary molded body is equal to or higher than 1000 kg/cm², the sintering temperature is equal to or higher than 1050°C and equal to or lower than 1120°C, and the sintering time is equal to or more than 2 hours, the LiCoO₂ sintered body having the relative density of 90% or more, the specific resistance value of 3 kΩ/cm or less, and the average particle size of equal to or larger than 20 µm and equal to or smaller than 50 µm can be obtained.

On the other hand, in the comparative example 1-1, since the sintering temperature was low, i.e., 950°C, the average particle size was small, i.e., about 7 µm. As a result, the relative density was low, i.e., 80%, and the specific resistance value was very high, i.e., 12 kΩ/cm. In the comparative example 1-2, since the sintering time was short, i.e., 1 hour, the relative density is low, i.e., 88%, and the specific resistance value is relatively high, i.e., 7 kΩ/cm. On the other hand, in the comparative example 1-3, since the sintering temperature was high, i.e., 1130°C, the average particle size was relatively large, i.e., 100 µm. As a result, the hardness becomes high and the break was likely to be generated during the processing of the sintering body.

### (Example 2)

### (Example 2-1)

A LiCoO₂ raw material powder ("cell seed (registered trademark) C-5" manufactured by Nippon Chemical industrial Co., LTD.) having an average particle size of 5 to 6 µm was added with a polyvinyl acetate binder of 2 wt% and was mixed with ethanol to be dried. After that, the resultant powder was subjected to a roll pulverizing, a classification, a CIP, a roll pulverizing, a classification, in the stated order and the powder thus granulated having an average particle size of 5 to 6 µm was CIP molded by using a rubber mold having a size of ϕ360 mm at 2000 kg/cm². The preliminary molded body thus obtained was held in the atmosphere at 300°C for 3 hours to remove the binder component and then was sintered at 1050°C for 8 hours. The break of the sintered body was not recognized during machine processing into the target shape. When performing a discharge test of the target, a sustained stable RF+DC discharge was confirmed. The relative density of the sintered body thus obtained was 90%, the specific resistance value was 3 kΩ/cm, and the average particle size was about 20 µm. The remaining carbon amount was confirmed to be equal to or less than 60 ppm.

It should be noted that, in relation to the remaining carbon amount, a compositional analysis of the sintered body was performed by ICP atomic emission spectroscopy and the remaining carbon amount was measured as an increasing amount of the amount of carbon due to the binder by a combustion infrared absorption method using a gas analyzing apparatus manufactured by LECO Corporation.

### (Example 2-2)

A LiCoO₂ raw material powder ("cell seed (registered trademark) C-5" manufactured by Nippon Chemical industrial Co., LTD.) having an average particle size of 5 to 6 µm was added with a polyvinyl acetate binder of 1 wt% and was mixed with ethanol to be dried. After that, the resultant powder was subjected to a pulverizing, a classification, a CIP, a pulverizing, a classification, in the stated order and the powder thus granulated was CIP molded by using a rubber mold having a size of ϕ360 mm at 2000 kg/cm². The preliminary molded body thus obtained was held in the atmosphere at 300°C for 1 hour to remove the binder component and then was sintered at 1120°C for 4 hours. The break of the sintered body was not recognized during machine processing into the target shape. When performing a discharge test of the target, a sustained stable RF+DC discharge was confirmed. The relative density of the sintered body thus obtained was 92%, the specific resistance value was 2 kΩ/cm, and the average particle size was about 40 µm. The remaining carbon amount was confirmed to be equal to or less than 60 ppm.

### (Example 2-3)

A LiCoO₂ raw material powder ("cell seed (registered trademark) C-5" manufactured by Nippon Chemical industrial Co., LTD.) having an average particle size of 5 to 6 µm was added with a polyvinyl acetate binder of 2 wt% and was mixed with ethanol to be dried. After that, the resultant powder was subjected to a roll pulverizing and the powder thus obtained was subjected to processing of pulverizing, mixing, and homogenizing by using a ball mill. As a result, the average particle size of the raw material powder was reduced to about 0.6 µm. The powder thus obtained was CIP molded by using a rubber mold having a size of ϕ360 mm at 2000 kg/cm². The preliminary molded body thus obtained was held in the atmosphere at 300°C for 3 hours to remove the binder component and then held at 650°C for 1 hour. After that, the temperature was raised to 1050°C and then the preliminary molded body was sintered at the same temperature for 8 hours. The break of the sintered body was not recognized during machine processing into the target shape. When performing a discharge test of the target, a sustained stable RF+DC discharge was confirmed. The relative density of the sintered body thus obtained was 95%, the specific resistance value was 0.5 kΩ/cm, and the average particle size was 30 µm. The remaining carbon amount was confirmed to be 60 ppm.

### (Example 2-4)

A LiCoO₂ raw material powder ("cell seed (registered trademark) C-5H" manufactured by Nippon Chemical industrial Co., LTD.) having an average particle size of 6 to 7 µm was added with a polyvinyl acetate binder of 2 wt% and was mixed with ethanol to be dried. After that, the resultant powder was subjected to a roll pulverizing and the powder thus obtained was subjected to processing of pulverizing, mixing, and homogenizing by using a ball mill. As a result, the average particle size of the raw material powder was reduced to about 0.6 µm. The powder thus obtained was CIP molded by using a rubber mold having a size of Ω360 mm at 2000 kg/cm². The preliminary molded body thus obtained was held in the atmosphere at 300°C for 3 hours to remove the binder component and then held at 650°C for 1 hour. After that, the temperature was raised to 1050°C and then the preliminary molded body was sintered at the same temperature for 8 hours. The break of the sintered body was not recognized during machine processing into the target shape. When performing a discharge test of the target, a sustained stable RF+DC discharge was confirmed. The relative density of the sintered body thus obtained was 94%, the specific resistance value was 0.6 kΩ/cm, and the average particle size was 30 µm. The remaining carbon amount was confirmed to be 60 ppm.

### (Comparative example 2-1)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ360 mm at 2000 kg/cm². The strength of the molded bodies was low, and 3 out of 6 molded bodies were broken. The preliminary molded bodies which were not broken were sintered in the atmosphere at 1120°C for 3 hours. One of the molded bodies after sintering was broken and the break of another molded body was recognized during machine processing. The relative density of the sintered body thus obtained was 92%, the specific resistance value was 3 kΩ/cm, and the average particle size was about 40 µm.

### (Comparative example 2-2)

A LiCoO₂ raw material powder ("cell seed (registered trademark) C-5" manufactured by Nippon Chemical industrial Co., LTD.) having an average particle size of 5 to 6 µm was CIP molded by using a rubber mold having a size of ϕ360 mm at 2000 kg/cm². The strength of the molded bodies was low, and most of the molded bodies were broken. The preliminary molded bodies which were not broken were sintered in the atmosphere at 1130°C for 3 hours. The relative density of the sintered body thus obtained was 93%, the specific resistance value was 3 kΩ/cm, and the average particle size was 80 µm.

The conditions and the results of the example 2 will be shown in table 2 collectively.

**[table 2]**

| | Molding pressure (kg/cm²) | Sintering temperature (°C) | Sintering time (h) | Specific resistance (kΩcm) | Relative density (%) | Average particle size (*µ*m) | Existence or non-existence of binder | Remark |
|---|---|---|---|---|---|---|---|---|
| Example 2-1 | 2000 | 1050 | 8 | 3 | 90 | 20 | Existence | |
| Example 2-2 | 2000 | 1120 | 4 | 2 | 92 | 40 | Existence | |
| Example 2-3 | 2000 | 1050 | 8 | 0.5 | 95 | 30 | Existence | Pulverization processing by ball mill |
| Example 2-4 | 2000 | 1050 | 8 | 0.6 | 94 | 30 | Existence | |
| Comparative example 2-1 | 2000 | 1120 | 3 | 3 | 92 | 40 | Non-existence | A lot of breaks |
| Comparative example 2-2 | 2000 | 1120 | 3 | 3 | 93 | 80 | Non-existence | A lot of breaks |

By mixing the raw material powder with the binder and using the granulated powder after molding and pulverizing, it is possible to manufacture a relatively large sintered body constantly. Moreover, when the molding pressure of the preliminary molded body is equal to or higher than 1000 kg/cm², the sintering temperature is equal to or higher than 1050°C and equal to or lower than 1120°C, and the sintering time is equal to or more than 2 hours, the LiCoO₂ sintered body having the relative density of 90% or more, the specific resistance value of 3 kΩ/cm or less, and the average particle size of equal to or larger than 20 µm and equal to or smaller than 50 µm can be obtained.

On the other hand, as shown in the comparative examples 2-1 and 2-2, with respect to the sintered body molded without mixing the raw material powder with the binder, regardless of the same molding condition and the same sintering condition as those of example 2, the break of the sintered body was recognized because the size of the sintered body was larger than that of the example 1.

Although the embodiment of the present invention was described, the present invention does not limited thereto, and various modifications can be made based on the technical concept of the present invention.

For example, in the embodiments described above, the molding pressure of the preliminary molded body was 1000 to 2000 kg/cm². However, the preliminary molded body may be manufactured at the molding pressure of higher than 2000 kg/cm². Further, in the embodiments described above, the sintering atmosphere of the preliminary molded body was the atmosphere. However, the sintering atmosphere may be the oxygen atmosphere.

Furthermore, in the embodiments described above, there were 2 types of the size of the preliminary molded body, i.e., ϕ150 mm and ϕ360 mm. However, the size is, of course, not limited to these. Whether the raw material powder was mixed with the binder may be determined based on the strength of the preliminary molded body to be manufactured and the sintered body to be manufactured.

### Description of Symbols

- DTA: differential thermal analysis
- TG: thermogravimetry
- DTG: change rate of thermogravimetry

## Claims

1. A manufacturing method for a LiCoO₂ sintered body, comprising:
molding a LiCoO₂ powder preliminarily by cold isostatic press method at a pressure of 1000 kg/cm² or more; and
sintering a preliminary molded body of the LiCoO₂ powder at a temperature of equal to or higher than 1050°C and equal to or lower than 1120°C.

2. The manufacturing method for a LiCoO₂ sintered body according to claim 1, wherein
the step of sintering the preliminary molded body holds the preliminary molded body at the temperature for 2 hours or more.

3. The manufacturing method for a LiCoO₂ sintered body according to claim 2, wherein
the step of sintering the preliminary molded body sinters the preliminary molded body in the atmosphere or in an oxygen atmosphere.

4. The manufacturing method for a LiCoO₂ sintered body according to claim 1, wherein
the step of molding the LiCoO₂ powder preliminarily includes a step of adding a binder to the LiCoO₂ powder, a step of molding the LiCoO₂ powder added with the binder by the cold isostatic press method, a step of pulverizing a molded body of the LiCoO₂ powder added with the binder, and a step of molding the LiCoO₂ powder thus pulverized by the cold isostatic press method.

5. The manufacturing method for a LiCoO₂ sintered body according to claim 4, further comprising
debinding the preliminary molded body of the LiCoO₂ powder including the binder at a temperature lower than a sintering temperature before the step of sintering the preliminary molded body.

6. A sputtering target including a LiCoO₂ sintered body and having a relative density of 90% or more, a specific resistance of 3 kΩ/cm or less, and an average particle size of equal to or larger than 20 µm and equal to or smaller than 50 µm.
